# EUROPEAN PATENT SPECIFICATION

(11) **EP 2 930 256 B1**
(45) Date of publication and mention of the grant of the patent: **07.11.2018**
(21) Application number: 14813518.9
(22) Date of filing: 16.06.2014
(51) Int. Cl.: C23C 18/18, C23C 18/30, C23C 18/20, C23C 18/38, H05K 3/18

(54) **METHOD FOR PRODUCING A METALLIC COATING FILM**
VERFAHREN ZUR HERSTELLUNG EINES METALLISCHEN BESCHICHTUNGSFILMS
PROCÉDÉ PERMETTANT DE PRODUIRE FILM DE REVÊTEMENT MÉTALLIQUE

(30) Priority: 21.06.2013 JP 2013131013
(43) Date of publication of application: 14.10.2015
(73) Proprietor: DIC Corporation, Tokyo 174-8520 (JP)
(72) Inventor: FUKAZAWA Norimasa, Sakura-shi Chiba 285-8668 (JP); NIIBAYASHI Shota, Sakura-shi Chiba 285-8668 (JP); SEKINE Nobuhiro, Sakura-shi Chiba 285-8668 (JP); SANO Yoshiyuki, Sakura-shi Chiba 285-8668 (JP); MORIWAKI Masayuki, Sakura-shi Chiba 285-8668 (JP); KAWAMURA Kaori, Sakura-shi Chiba 285-8668 (JP); OHTSUKA Kuniaki, Osaka-shi Osaka 538-0044 (JP); KANG Junhaeng, Osaka-shi Osaka 538-0044 (JP); MORIGUTI Tomo, Osaka-shi Osaka 538-0044 (JP)
(74) Representative: Adam, Holger
(86) International application number: PCT/JP2014/065848
(87) International publication number: WO 2014/203843

(56) References cited:
- EP-A2- 2 610 365
- JP-A- 2005 082 879
- JP-A- 2008 297 386
- JP-A- 2012 255 182
- JP-A- 2013 151 749
- US-A1- 2002 197 404
- US-A1- 2012 280 186

## Description

### TECHNICAL FIELD

The present invention relates to a method for producing an electroless plating metal film using metal nanoparticles protected with an anionic compound.

### BACKGROUND ART

Various precious metals are used as catalysts for electroless plating, and palladium is the most widely used among these metals. The two methods described below are mainly used for adsorbing the precious metal catalyst to the object to be plated.

(1) A method in which the object to be plated is dipped in a sensitizer solution (a hydrochloric acid solution of palladium chloride), and the palladium salt is then reduced on the object to be plated, thus obtaining a palladium colloid-deposited substrate (the sensitizer-activator method).
(2) A method in which the object to be plated is dipped in a tin-palladium mixed colloidal solution, and following adhering of the colloid to the object to be plated, the object is dipped in an accelerator solution composed of an acidic solution of sulfuric acid or the like, thereby dissolving the excess tin ions and generating catalytic activity (the catalyst-accelerator method).

In other words, in most typical methods, a compound of the catalytic metal is first deposited on the surface of the object to be plated, and this compound is then converted to reduced metal microparticles which exhibit catalytic activity, but these methods require two stages (deposition and activation), and are not only extremely complex, but because of the increased number of process steps, also suffer from increased process costs.

In contrast, methods which do not require a reduction operation, in which prepared metal nanoparticles (or a metal colloid) are deposited on the object to be plated and used as a catalyst, have been the subject of development for many years, and methods that use palladium colloids, or economically more viable metal types such as silver colloids, silver nanoparticles or copper nanoparticles, have been proposed (for example, see Patent Documents 1 to 4 and Non-Patent Documents 1 and 2). However, for reasons including poor bath stability and an inability to achieve adequate deposition of the catalyst, this type of method is not applicable for applications such as multilayered electronic circuit boards which require superior reliability, applications with require superior adhesive strength between a copper plated coating film and a plastic substrate or between copper foils, or applications in which uniform deposition within very fine holes or gaps is problematic, and in such cases, the aforementioned type of complex two-stage plating method is used almost exclusively.

In applications such as electronic circuit formation, glass and plastic substrates are extremely important and of much value industrially as objects for plating, but an adequate amount of catalyst can not be deposited on these substrates simply by dipping the substrates in the types of catalyst solutions described above. Accordingly, the objects to be plated must be subjected to some form of surface pretreatment. Examples of these types of pretreatments include methods in which an anionic or cationic compound is deposited on the surface of the object to be plated. This imparts the surface of the object to be plated with an electrical charge, enabling ions of the catalytic metal or charged catalyst particles to adsorb electrostatically. Generally, cationic compounds adsorb more readily to glass and plastic surfaces, and also exhibit better adsorption stability, meaning they are less likely to be removed in the plating bath. As a result, pretreatment using cationic compounds is advantageous and generally preferred (for example see Patent Document 5 and Non-Patent Document 2).

Patent Document 5 and Non-Patent Document 2 describe a method in which a silver colloidal particle catalyst prepared by an Sn-Ag reduction method is deposited on the surface of an object to be plated that has been pretreated with a cationic polymer. The silver colloidal particles prepared using this method include tin oxide-based compounds, meaning both catalyst particles and tin compounds having no catalytic activity are adsorbed in competition on the object to be plated, and therefore it is difficult to achieve homogeneous adsorption of a satisfactory amount of the catalyst on the surfaces of objects to be plated such as ABS resins, epoxy resins, glass and ceramics, and if the method is used industrially, it tends to be the cause of plating defects and adhesion faults.

US 2012/0280186 A1 provides a composite of nanoparticles of a metal such as gold, silver, a platinum metal, or copper, and a polymer, the composite allowing formation of a metal film having a sufficiently low resistivity in terms of practicality simply by drying at room temperature without requiring any special heating-baking step or any step of removing a protective agent with a solvent.

US 2002/0197404 A1 discloses a method of activating a non-conductive substrate for use in electroless deposition, in which an aqueous solution containing nanoparticles of noble metals and their alloys is used as an activation solution in an electroless plating process, so as to electrolessly deposit a conductive metal deposition on the substrate and into micrometer-sized trenches formed on the substrate.

EP 2 610 365 A2 discloses a solution including a precious metal nanoparticle and a polymer polymerized from a monomer comprising at least a monomer having two or more carboxyl groups or carboxylic acid salt groups.

JP 2005 082879 A provides a method capable of forming a satisfactory electroless plating film free from undeposited parts and unevenness in appearance even in the case an inexpensive silver compound low in catalytic activity is used as a catalyst.

Further, in colloidal catalyst systems that use tin compounds, a tin removal step is required before the electroplating process, and not only this step is complex, but impurities such as chloride ions derived from the tin compounds tend to remain even after the removal step, and therefore problems such as the formation of metal whiskers and ion migration of formed electronic circuit, which can impair the reliability of electronic circuits, cannot be entirely eradicated.

### PRIOR ART LITERATURE

### Patent Documents

Patent Document 1: Japanese Unexamined Patent Application, First Publication No. Sho 61-227175
Patent Document 2: Japanese Unexamined Patent Application, First Publication No. Sho 62-207877
Patent Document 3: Japanese Unexamined Patent Application, First Publication No. Sho 64-68478
Patent Document 4: Japanese Unexamined Patent Application, First Publication No. Hei 10-229280
Patent Document 5: Japanese Unexamined Patent Application, First Publication No. 2005-82879

### Non-Patent Documents

Non-Patent Document 1: A. Vaskelis et al., Electrochim. Acta 2005, 50, 4586.
Non-Patent Document 2: Ohno et al., J. Electrochem. Soc. 1985, 132, 2323.
Non-Patent Document 3: Takahashi et al., Journal of the Surface Finishing Society of Japan, 2007, 58(12), 841.

### DISCLOSURE OF INVENTION

### Problems to be Solved by the Invention

An object of the present invention is to provide a method for producing a metal film which, by employing the above catalyst for electroless plating, is able to produce excellent throwing power into very small areas and excellent adhesion to metal films deposited on, and can therefore be used favorably for metal film formation on the interlayer connection portions (through-holes and via holes) of multilayered electronic circuit boards.

### Means for Solving the Problems

As a result of intensive research aimed at achieving the above objects, the inventors of the present invention discovered that by using a complex of a compound having a specific anionic functional group and metal nanoparticles as a catalyst for electroless plating, the two stages of steps conventionally used were unnecessary, meaning the number of steps could be reduced, and the resulting plating catalyst solution was stable, enabled the deposition of a satisfactory amount of the catalyst to the object to be plated, and was able to form a favorable metal film. Moreover, they also discovered that by using the specific complex mentioned above as a catalyst, the object to be plated need only be treated using a general cationization method, good throwing power could be achieved to through-holes and via holes of multilayered electronic circuit boards, and satisfactory adhesion of the plating film to insulating materials and copper wiring and the like could be ensured, and this enabled the inventors to complete the present invention.

In other words, the present invention provides a method for producing an electroless plating metal film, using, as a catalyst, a complex of a compound (X) and metal nanoparticles (Y), in which the compound (X) is produced by polymerizing a monomer mixture (I) comprising a (meth)acrylic acid-based monomer having at least one anionic functional group selected from the group consisting of a carboxyl group, a phosphoric acid group, a phosphorous acid group, a sulfonic acid group, a sulfinic acid group and a sulfenic acid group, the method comprising:
(1) a step of treating a surface of an object to be plated with a cationic treatment agent (a),
(2) a step of dipping the object to be plated that has been subjected to step (1) in a catalyst for electroless plating comprising said catalyst dispersed in an aqueous solvent, thereby adsorbing the complex of the compound (X) and the metal nanoparticles (Y) to a surface of the object to be plated, and
(3) a step of dipping the complex-adsorbed object to be plated obtained in step (2) in a solution of metal ions (b) for performing electroless plating, wherein
   the monomer mixture (I) further comprises a (meth)acrylic acid-based monomer having a polyethylene glycol chain in which an average number of ethylene glycol units is 20 or greater, and
   an average particle size of the metal nanoparticles (Y) determined from a transmission electron microscope photograph is within a range from 0.5 to 100 nm.

### Effects of the Invention

The catalyst for electroless plating according to the present invention is a complex of a compound having an anionic functional group and metal nanoparticles, and this complex can be used favorably in a catalyst solution prepared by dispersing the complex in an aqueous solvent. By using this type of complex of an anionic compound having a specific structure and metal nanoparticles, the electrical charge of the complex and the effect of the steric repulsion group enables the catalyst solution containing the dispersed complex to exhibit excellent dispersion stability, with no coagulative precipitation, even in a heated state. As a result, retention of the catalytic activity after initial make-up of electrolytic bath is extremely good, process management is simple, and satisfactory adsorption of catalyst (catalyst deposition) can be achieved to the surfaces of objects to be plated that have been pretreated with a typical cationization agent.

Further, ionic impurities can be removed from the complex of the catalyst for electroless plating according to the present invention by known purification methods such as centrifugal separation or ultrafiltration, and therefore the catalyst can also be used favorably in plating catalyst applications which require superior reliability, such as the production of electronic circuit boards.

Moreover, the metal film obtained using the catalyst for electroless plating according to the present invention compares favorably with plated coating films obtained using conventional palladium-based catalysts. Further, in those cases when a complex of silver or copper nanoparticles is used as the catalyst, associated costs are extremely cheap compared with palladium, and the risk of price fluctuations is also minimal, meaning significant economic benefits can be expected.

In addition, by using the catalyst for electroless plating and the method for producing a metal film according to the present invention, the number of process steps can be reduced compared with conventionally used electroless plating processes, thus enabling a significant reduction in the process costs.

### BRIEF DESCRIPTION OF THE DRAWINGS

FIG. 1 illustrates cross-sectional SEM photographs [(a) magnification: 1,000×, (b) magnification: 5,000×] of a build-up substrate in which a via hole is formed that has been subjected to a plating using a catalyst solution 4 in Example 2.
FIG. 2 illustrates cross-sectional SEM photographs [(a) magnification: 1,000×, (b) magnification: 5,000×] of a build-up substrate in which a via hole is formed that has been subjected to a plating treatment using an Sn-Pd catalyst solution used in Comparative Example 1 in Example 2.

### BEST MODE FOR CARRYING OUT THE INVENTION

### [Catalyst for Electroless Plating: Complex of Compound (X) and Metal Nanoparticles (Y)]

### <Compound (X)>

The catalyst for electroless plating used in the present invention is a complex of a compound (X) and metal nanoparticles (Y), wherein the compound (X) is produced by polymerizing a monomer mixture (I) containing a (meth)acrylic acid-based monomer, namely a polymerizable monomer having an acryloyl group or a methacryloyl group, having at least one anionic functional group selected from the group consisting of a carboxyl group, a phosphoric acid group, a phosphorous acid group, a sulfonic acid group, a sulfinic acid group and a sulfenic acid group, and this complex can be dispersed in an aqueous solvent and used as a catalyst solution.

The aforementioned carboxyl group, phosphoric acid group, phosphorous acid group, sulfonic acid group, sulfinic acid group or sulfenic acid group has a function of being able to adsorb to the metal nanoparticles (Y) via the unshared electron pair on the hetero atom, and also imparts a negative electrical charge to the surface of the metal nanoparticles (Y), and can therefore prevent the coagulation of colloidal particles by generating charge repulsion between the particles, thus enabling the complex of the compound (X) and the metal nanoparticles (Y) to be dispersed stably within an aqueous solvent.

The method used for introducing the anionic functional groups into the compound (X) used in the present invention may be any method that involves polymerization of the monomer mixture (I) containing the (meth)acrylic acid-based monomer having the anionic functional group as an essential component, and a method that involves polymerization of a monomer mixture composed of the (meth)acrylic acid-based monomer is particularly preferable.

For example, the compound (X) containing carboxyl groups can be obtained easily by homopolymerization of (meth)acrylic acid, or copolymerization by any of various methods of a monomer mixture containing (meth)acrylic acid and another (meth)acrylic acid-based monomer. Similarly, the compound (X) containing phosphoric acid groups or phosphorus acid groups can be obtained easily by homopolymerization of a (meth)acrylic acid-based monomer having a phosphoric acid group, or by copolymerization of a mixture prepared by mixing such a (meth)acrylic acid-based monomer having a phosphoric acid group with another monomer. Moreover, the introduction of sulfonic acid groups, sulfinic acid groups or sulfenic acid groups into the compound (X) can be performed in a similar manner, for example by polymerizing a monomer mixture containing a (meth)acrylic acid-based monomer having a sulfonic acid group.

The compound (X) may be either a homopolymer or a copolymer, and in particular, may be a copolymer having a plurality of types of the anionic functional groups described above. There are no particular limitations on the structure of the copolymer, and both random and block copolymers can be used favorably. Further, a mixture of two or more compounds (X) having different anionic functional groups may also be used.

Although there are no particular limitations on the number of the aforementioned specific anionic functional groups introduced into the compound (X), from the viewpoint of the adsorption of the compound to the metal nanoparticles (Y) and the dispersion stability upon preparation as a dispersion, each molecule of the compound preferably includes 3 or more of the anionic functional groups.

Although there are no particular limitations on the weight-average molecular weight of the compound (X), from the viewpoint of the effects of the complex of the compound (X) with the metal nanoparticles (Y) as an electroless plating catalyst (such as the adsorption to substrates and the dispersion stability upon preparation as a dispersion), the weight-average molecular weight is preferably from 3,000 to 20,000, and more preferably from 4,000 to 8,000.

Furthermore, a polyethylene glycol chain that provides good dispersion stability by spreading out and occupying an appropriate volume within the medium is also incorporated within the compound (X) molecule, as this enables a colloid protection action due to a steric repulsion effect to be realized at the same time as the repulsion effect due to the electrical charge.

For example, this type of structure can be obtained easily by including a (meth)acrylic acid-based monomer having a polyethylene glycol chain in the aforementioned monomer mixture (I), and then copolymerizing this monomer with (meth)acrylic acid, a (meth)acrylic acid having a phosphoric acid group, or a (meth)acrylic acid having a sulfonic acid group or the like.

A compound (X) having an anionic functional group that is obtained by a polymerization using a (meth)acrylic acid-based monomer having a polyethylene glycol chain in which the average number of ethylene glycol units is 20 or greater has a particularly superior ability to stabilize nanoparticles of precious metals, and particularly silver and copper nanoparticles, meaning the compound acts as an ideal protective agent, and is consequently used. Synthesis and the like of this type of compound having an anionic functional group and a polyethylene glycol chain can be achieved easily by reference to Japanese Patent (Granted) Publication No. 4,697,356 or Japanese Unexamined Patent Application, First Publication No. 2010-209421 or the like.

The weight-average molecular weight of the aforementioned (meth)acrylic acid-based monomer having a polyethylene glycol chain in which the average number of ethylene glycol units is 20 or greater is preferably from 1,000 to 2,000. If the weight-average molecular weight satisfies this range, then the water dispersibility of the complex with the metal nanoparticles (Y) is particularly favorable. Compounds for which the weight-average molecular weight exceeds 2,000 are not readily available commercially, and therefore it is difficult to cheaply acquire the raw materials.

For example, the compound (X) can be obtained by copolymerizing a commercially available 2-methacryloyloxy phosphate (for example, "Light Ester P-1M" manufactured by Kyoeisha Chemical Co., Ltd.) and a commercially available methacrylate ester monomer having a polyethylene glycol chain (for example, "Blemmer PME-1000" manufactured by NOF Corporation) with an arbitrary polymerization initiator (for example, the oil-soluble azo polymerization initiator "V-59").

At this time, if the mass fraction of the (meth)acrylate ester monomer having a phosphoric acid group is less than 30% of the monomer mixture (I), then the generation of by-products such as homopolymers of the (meth)acrylic acid-based monomer having the polyethylene glycol chain that do not participate in the protection of the metal nanoparticles (Y) can be suppressed, thereby improving the dispersion stability provided by the obtained compound (X).

The monomer mixture (I) described above may also include a third polymerizable monomer besides the (meth)acrylic acid-based monomer having an anionic functional group and the (meth)acrylic acid-based monomer having a polyethylene glycol chain. In this case, if the third polymerizable monomer is a hydrophobic monomer, then in order to ensure favorable water dispersibility, the mass fraction of the third polymerizable monomer relative to the (meth)acrylic acid-based monomer having a polyethylene glycol chain is preferably not more than 20%, and is more preferably 10% or less. If the third polymerizable monomer is not a hydrophobic monomer, then the mass fraction is not limited to this range.

As mentioned above, the weight-average molecular weight of the compound (X) is preferably within a range from 3,000 to 20,000, but when a (meth)acrylic acid-based monomer having a polyethylene glycol chain is used as part of the monomer mixture, the compound (X) obtained from the polymerization reaction has a molecular weight distribution. A smaller weight-average molecular weight indicates a compound that does not contain a structure derived from the (meth)acrylic acid-based monomer having a polyethylene glycol chain, and this type of compound does not contribute to the dispersion stability when the complex with the metal nanoparticles (Y) is dispersed in an aqueous medium, and for this reason, the weight-average molecular weight of the compound (X) is preferably at least 4,000. In contrast, if the weight-average molecular weight becomes too large, then the complex with the metal nanoparticles (Y) tends to become overly coarse and prone to precipitation within the catalyst solution, and therefore the weight-average molecular weight of the compound (X) is preferably not more than 8,000.

In order to ensure that the weight-average molecular weight of the compound (X) satisfies the above range, the type of chain transfer agent disclosed in the literature, such as in Japanese Unexamined Patent Application, First Publication No. 2010-209421, may be used, or the molecular weight may be controlled by adjusting the polymerization conditions without using a chain transfer agent.

If the surface of the object to be plated is cationic, then the metal nanoparticles (Y) that have been complexed with this type of compound (X) having an anionic functional group can adsorb effectively to the surface of the object to be plated, and the catalyst can be adsorbed to the surface of the object to be plated in a high concentration simply by dipping the object in the solution of the complex. Further, the catalyst can be adsorbed homogeneously within very fine indentations and in through-holes and non-through holes, regardless of the shape of the object to be plated, and as a result, plating deposition with good throwing power can be achieved.

In this manner, the electroless plating catalyst used in the present invention adsorbs to the surface of cationic objects to be plated via an electrostatic interaction of the anionic functional groups contained within the compound (X), and in the case of a compound (X) that incorporates a polyethylene glycol chain, the steric repulsion effect provided by these chains can suppress aggregation, not only within the catalyst solution but also on the object to be plated, meaning a more uniform plating film can be formed.

### <Metal Nanoparticles (Y)>

As mentioned above, the catalyst for electroless plating used according to the present invention is a complex with metal nanoparticles (Y) of silver, copper or palladium, produced using the aforementioned compound (X) as a colloid protective agent.

By dissolving or dispersing the compound (X) in an aqueous medium, subsequently adding a metal compound such as silver nitrate, copper acetate or palladium nitrate to the medium, and then mixing a reducing agent into the medium, if necessary after the addition of a complexing agent to obtain a uniform dispersion, or alternatively at the same time as the complexing agent, the metal compound is reduced, and the reduced metal forms as nano-size particles (very fine particles having a size in the order of nanometers), and at the same time yields an aqueous dispersion of the metal nanoparticles (Y) complexed with the compound (X).

In the present invention, the aqueous dispersion of the complex containing the metal nanoparticles (Y), obtained using the type of method described above, may be used as a catalyst solution for electroless plating without any further modification, or the aqueous dispersion may be subjected to one or more purification steps by using any of various purification methods such as ultrafiltration, precipitation, centrifugal separation, reduced-pressure distillation or reduced-pressure drying to remove excess complexing agent, reducing agent or the counter ions contained within the metal compound used as a raw material, or this purified dispersion may be further subjected to alterations of the concentration (non-volatile fraction) or replacement of the aqueous medium to form a new dispersion. When the aqueous dispersion is to be used for a packaging application, such as the formation of an electronic circuit, the use of an aqueous dispersion that has been subjected to the aforementioned types of purification steps is preferable.

The complex obtained by protecting the metal nanoparticles (Y) with the compound (X) comprises, as components, the compound (X) described above, and the metal nanoparticles (Y), which have an average particle size within a range from 0.5 to 100 nm.

The size of these metal nanoparticles (Y) can be estimated from transmission electron microscope photographs, and particles for which the average particle size of 100 particles is within a range from 0.5 to 100 nm can be easily obtained by using the method disclosed in the aforementioned Japanese Patent (Granted) Publication No. 4,697,356 or Japanese Unexamined Patent Application, First Publication No. 2010-209421 or the like. The metal nanoparticles (Y) obtained in this manner exist as individual particles protected by the compound (X), and exist stably at room temperature without undergoing fusion. In terms of obtaining a more dense and uniform metal-coated substrate, the use of metal nanoparticles (Y) having an average particle size of 0.5 to 50 nm as the electroless plating catalyst is particularly preferred.

The particle size of the metal nanoparticles (Y) can be controlled easily by altering factors such as the type of metal compound, the molecular weight, chemical structure and amount used of the compound (X) that functions as the colloid protective agent, the type and amount used of the complexing agent and the reducing agent, and the temperature during the reduction reaction. Details regarding these factors are provided in the examples within the patent documents mentioned above.

The type of metal within the metal nanoparticles (Y) may be any metal capable of functioning as a catalyst in the electroless plating process, and although there are no particular limitations, from the viewpoints of the catalytic activity and stability of the complex within aqueous media, silver, copper and palladium are preferable, and from the viewpoint of achieving effective conductivity by unifying the metal film after the plating process, particles composed solely of silver or copper, or silver core-copper shell particles or copper shell-silver core particles are preferable, and particles formed solely from silver are the most desirable from an economic viewpoint. In the case of silver nanoparticles, particles for which the average particle size is within a range from 5 to 50 nm are the most preferred as a catalyst.

Further, the content ratio of the compound (X) in the complex of the compound (X) and the metal nanoparticles (Y) is typically from 1 to 30% by mass, and preferably from 2 to 20% by mass of the complex. In other words, the fact that the metal nanoparticles (Y) occupy the majority of the mass in the complex is ideal for enabling uniform and stable formation of the plating metal film in the subsequent plating process.

The complex can be dispersed in an aqueous medium, namely either water or a mixed solvent containing water and a miscible organic solvent, in an amount within a range from about 0.001 to 70% by mass, and the resulting dispersion can be stored stably at room temperature (about 25°C) for several months with no aggregation.

### <Catalyst Solution for Electroless Plating>

The catalyst for electroless plating used according to the present invention can be used in the form of a catalyst solution obtained by dispersing the complex described above in an aqueous medium. In terms of ensuring a good amount of adsorption to the object to be plated, and achieving favorable adhesion of the metal film to the object to be plated, the concentration (non-volatile fraction concentration) of the catalyst for electroless plating is preferably within a range from 0.05 to 5 g/L, and if economic factors are also taken into consideration, then the concentration is preferably adjusted to a value within a range from 0.1 to 2 g/L, and even more preferably a value within a range from 0.2 to 2 g/L.

Examples of aqueous media that can be used favorably in the catalyst solution for electroless plating include water by itself, and mixed solvents containing water and a miscible organic solvent. This organic solvent that is miscible with water may be selected without any particular restrictions, provided that it does not impair the dispersion stability of the complex, and does not cause unnecessary damage to the object to be plated. For example, one solvent or a mixture of a plurality of solvents selected from among methanol, ethanol, isopropanol and acetone can be used according to need.

In the aqueous medium used in the catalyst solution for electroless plating, the mixing proportion of the organic solvent that is mixed with and miscible with water is preferably not more than 50% by mass from the viewpoint of the dispersion stability of the complex, and is more preferably 30% by mass or less from the viewpoint of usability within the plating process.

### [Object to be Plated (Substrate for Electroless Plating)]

There are no particular limitations on the objects that can be plated using the dispersion of the catalyst for electroless plating (the catalyst solution for electroless plating) according to the present invention, provided the complex described above can be adsorbed to the object. Examples of the material of the object to be plated include plastics such as glass fiber-reinforced epoxy resins, epoxy-based insulating materials, polyimides and PET, as well as glass, ceramics, metal oxides, metals, paper, and synthetic or natural fibers, and a single material or a combination of a plurality of materials may be used. The shape of the object to be plated may be any shape such as a plate-like or film-like shape, a cloth-like or fiber-like shape, or a tube-like shape. Particularly in those cases when the complex to be adsorbed is used in the form of an aqueous dispersion, the object to be plated preferably exhibits favorable water wetting tendencies, namely a water contact angle for the surface of the object to be plated of 75° or less. Further, even in the case of a material that is resistant to wetting with water, provided the material can be either subjected to a surface treatment such as plasma irradiation, corona discharge, ultraviolet irradiation, ozone treatment or etching, or can be imparted with surface hydrophilicity by treatment with an acid or alkali, the material can still be used favorably. The method used for the surface treatment may be either one of the treatment methods mentioned above, or a combination of a plurality of the treatment methods.

By using a dispersion of the catalyst for electroless plating according to the present invention, a uniform metal film can be formed easily on the object to be plated, and therefore the present invention is suitable for plating electronic materials, and can be used particularly favorably in applications where a resin substrate for a circuit board, a copper-clad circuit board, an epoxy-based insulating material or a ceramic substrate or the like is used as the object to be plated.

When an aqueous dispersion of the complex is used as a catalyst for electroless plating, by using the aqueous dispersion to treat the object to be plated, either as is, following washing with water, or following washing with water and then drying, metal nanoparticles having catalytic activity can be easily deposited on the object to be plated.

### [Process for Preparing Metal Film by Electroless Plating Method]

A method for producing a metal film using the catalyst for electroless plating according to the present invention is a method in which the conventional palladium catalyst typically used in the preparation process for an electroless plated metal film is replaced with a complex composed of the compound (X) and the metal nanoparticles (Y) described above, and is an electroless plating process that has been optimized to obtain the catalytic effects of the catalyst for electroless plating according to the present invention.

In other words, the method for producing a metal film according to the present invention includes:
(1) a step of treating the surface of the object to be plated with cationic treatment agent (a),
(2) a step of dipping the treated object to be plated from step (1) into a catalyst solution for electroless plating containing the catalyst described above dispersed in an aqueous medium, thereby adsorbing a complex of the compound (X) and the metal nanoparticles (Y) to the surface of the object to be plated, and
(3) a step of dipping the complex-adsorbed object to be plated obtained in step (2) into an aqueous solution of metal ions (b) for performing electroless plating, wherein the monomer mixture (I) further comprises a (meth)acrylic acid-based monomer having a polyethylene glycol chain in which an average number of ethylene glycol units is 20 or greater, and an average particle size of the metal nanoparticles (Y) determined from a transmission electron microscope photograph is within a range from 0.5 to 100 nm.

Preferably, in the inventive method for producing an electroless plating metal film a weight-average molecular weight of the compound (X) is within a range from 3,000 to 20,000.

Preferably, in the inventive method for producing an electroless plating metal film the metal of the metal nanoparticles (Y) is silver, copper or palladium.

Preferably, in the inventive method for producing an electroless plating metal film an average particle size of the metal nanoparticles (Y) determined from a transmission electron microscope photograph is within a range from 0.5 to 100 nm.

### [Step (1) (Cationization Treatment of Surface of Object to be Plated]

In the production method of the present invention, in step (1), the surface of the object to be plated is treated with the cationic treatment agent (a), but if necessary, any of various cleaning steps or etching steps may be inserted before step (1) for the purpose of removing matter adhered to the substrate surface of the object to be plated or hydrophilizing the surface of the object to be plated.

In step (1) of the production method of the present invention, the cationic treatment agent (a) used in the cationization treatment of the object to be plated is a composition containing a cationic compound, and compositions obtained by dissolving or dispersing any of various cationic surfactants or compounds containing a cationic functional group (such as an amino group or an ammonium salt) in an aqueous medium can be used.

Examples of cationic compounds that can be used favorably include cationic surfactants that are available commercially as higher alkyl monoamine salts such as monoalkyl amine salts (acetates), alkyl diamine salts such as N-alkyl propylene diamine dioleates and quaternary ammonium salts such as alkyltrimethylammonium salts (chlorides) (wherein the carbon number of the alkyl group is typically from 6 to 32, and preferably about 8 to 24), and cationic polymers such as polyethyleneimines, polyallylamines, polyallylamine salts (hydrochlorides and sulfates), polyallylamine salt-diallylamine salt copolymers and polyanilines (for which the weight-average molecular weight is about 1,000 to 100,000, and preferably from 5,000 to 20,000).

The cationic treatment agent (a) is typically a solution prepared by dissolving or dispersing the cationic compound in an aqueous medium at a concentration within a range from 0.01 to 50 g/L, and preferably from 0.1 to 20 g/L. If a compound is used for which uniform dissolution or dispersion is difficult within the above concentration range, then an organic solvent that is miscible with water may be used in combination with the water.

The cationic treatment agent (a) may use boric acid, phosphoric acid, ammonium chloride, ammonia, carbonic acid or acetic acid or the like as a pH buffer. The amount used of the pH buffer is preferably from 1 to 50 g/L, and more preferably from 1 to 20 g/L.

In the aforementioned step (1), there are no particular limitations on the method used for treating the surface of the object to be plated with the cationic treatment agent (a), and the object to be plated may be dipped in the cationic treatment agent (a), or the cationic treatment agent (a) may be applied to the surface of the object to be plated, but in those cases where plating into very fine portions is required, such as the plating of the interlayer connection portions (through-holes and via holes) of multilayered electronic circuit boards, a method in which the object to be plated is treated by dipping in the cationic treatment agent (a) is the simplest and most preferred. There are no particular limitations on the conditions for this dipping treatment, and the dipping of the object to be plated is usually performed with the temperature of the cationic treatment agent (a) set to about 10 to 80°C, and preferably 20 to 50°C. The dipping time is preferably within a range from about 1 to 20 minutes, and more preferably from 2 to 10 minutes.

The treatment with this type of cationic treatment agent (a) is used because the surfaces of most objects to be plated are typically on the acidic side, because the effects of the cationization treatment on the object to be plated are more readily maintained in the subsequent plating process that includes water washing and soft etching and the like, and because compared with an anionization treatment, the process is simpler and greater stability can be imparted to formation of the plating metal film.

### [Step (2) Catalyst Deposition Step (Method of Depositing Plating Catalyst)]

There are no particular limitations on the method used for depositing the complex containing the metal nanoparticles that function as the catalyst for electroless plating onto the surface of the object to be plated that has undergone treatment with the aforementioned cationic treatment agent (a) (the treated object to be plated), and for example, a method in which the treated object to be plated is dipped in the catalyst solution, or a method in which the catalyst solution is applied to the treated object to be plated may be used. However, in those cases where the treated object to be plated includes very fine structures and plating into very fine portions is required, such as the interlayer connection portions (through-holes and via holes) of multilayered electronic circuit boards, a method in which the treated object to be plated is dipped in the catalyst solution is preferred, as this type of method enables the catalyst (metal nanoparticles complex) to be deposited homogeneously to objects to be plated having very fine portions via a simple operation.

There are no particular limitations on the dipping conditions used when depositing the catalyst onto the surface of the treated object to be plated, but the temperature of the catalyst solution (aqueous dispersion) is typically set to 5 to 70°C, and preferably about 10 to 60°C, and the treated object to be plated obtained in the aforementioned step (1) is then simply dipped in the catalyst solution.

There are no particular limitations on the time for which the treated object to be plated is dipped in the catalyst solution, provided the targeted plating metal coating film can be formed in the subsequent electroless plating step, and for dipping times up to about 30 minutes, the amount of adsorption of the catalyst (the complex containing the metal nanoparticles) increases as the dipping time is increased, but if dipping is performed for longer periods of time, then there is almost no further increase in the amount of catalyst adsorption, and therefore from the viewpoint of reducing process costs, the dipping time is preferably not more than 30 minutes, and a catalyst layer that is sufficient to obtain the targeted plating film can usually be obtained with a dipping time of about 2 to 15 minutes.

### [Step (3) Electroless Plating Step]

A metal film can be formed on the surface of the object to be plated by dipping the complex-adsorbed object to be plated obtained following step (1) and step (2) described above into the aqueous solution of metal ions (b) (electroless plating solution) used for performing electroless plating.

### <Electroless Plating Solution (b)>

Various electroless plating solutions can be used, and examples of these types of electroless plating solutions include a solution for electroless nickel plating and a solution for electroless copper plating, as well as electroless plating solutions for precious metals such as gold, silver, palladium and rhodium. These electroless plating solutions are available commercially, and an appropriate solution can simply be selected, purchased and used in accordance with the desired purpose.

From the viewpoint of practicality, the use of an electroless plating solution containing copper ions is preferable. By using the production method of the present invention, a copper-coated substrate can be obtained easily, and therefore the present invention enables glass epoxy copper-clad laminates (glass epoxy substrate) known conventionally as FR-4 and multilayered electronic circuit boards to be produced cheaply, and from raw materials that have minimal toxicity.

The deposited metal film obtained by the electroless plating described above may be used without further modification as a conductive coating film, or additional electroplating may be subsequently performed to form a metal film of the desired thickness. Moreover, a portion of the obtained metal film may be removed by etching or the like to form a pattern. Moreover, a conductive pattern can also be formed by adsorbing the catalyst layer to a portion of the surface of the object to be plated, patterning the catalyst layer, and then performing electroless plating. In other words, if a composition containing the catalyst solution is printed onto the surface of the object to be plated using any of various printing methods that enable the formation of a pattern, then the electroless plating film can be formed on the printed portions, meaning the metal film can be patterned to obtain a conductive pattern.

### EXAMPLES

The present invention is described below in further detail using a series of examples, but the present invention is in no way limited by these examples. Unless specifically stated otherwise, the units "parts" and "%" refer to mass-referenced values.

The analytical instruments used in the present invention were as follows.
¹H-NMR: AL300, 300 Hz, manufactured by JEOL Ltd.
TEM observation: JEM-2200FS, manufactured by JEOL Ltd.
Electrical conductivity: B-173, manufactured by Horiba, Ltd.
SEM observation: S-3400, manufactured by Hitachi High-Technologies Corporation.
TG-DTA measurement: TG/DTA6300, manufactured by SII NanoTechnology Inc.
Plasmon absorption spectra: UV-3500, manufactured by Hitachi, Ltd.
Dynamic light scattering particle size measurement: FPAR-1000, manufactured by Otsuka Electronics Co., Ltd.
Surface resistivity measurement: Low Resistivity Meter Lorester EP (4-terminal method), manufactured by Mitsubishi Chemical Corporation.
Amount of catalyst adsorption: ICP Optical Emission Spectrometer SPS3100, manufactured by SII NanoTechnology Inc.

### [Synthesis Examples for Complexes of Compounds having an Anionic Functional Group and Metal Nanoparticles]

The complexes used in the present invention and the aqueous dispersions thereof were produced in the manner described below, based on Japanese Unexamined Patent Application, First Publication No. 2010-209421 and Japanese Patent (Granted) Publication No. 4,697,356.

### <Synthesis Example 1: Synthesis of Complex of Compound having Phosphoric Acid Group and Silver Nanoparticles> (not part of the invention)

### [Synthesis of Compound (X-1) having Phosphoric Acid Group]

Under a nitrogen atmosphere, a reaction vessel was charged with 210 g of ethanol and 174 g of 2-butanone, and the mixture was heated to 75°C under stirring. A mixed solution prepared by dissolving 600 g of Light Ester P-1M (manufactured by Kyoeisha Chemical Co., Ltd.) in a mixed solvent of 90 g of ethanol and 90 g of 2-butanone was then added dropwise to the reaction vessel over a period of 3.5 hours, and a solution prepared by dissolving 3 g of a polymerization initiator V-59 and 18 g of a chain transfer agent (methyl 3-mercaptopropionate) in 30 g of 2-butanone was also added dropwise simultaneously over a period of 4.5 hours. Heating was halted 21 hours after the start of the reaction, and following cooling to room temperature, 300 g of distilled water was added. The solvents were removed by distillation under reduced pressure using a rotary evaporator, a further 100 g of distilled water was added, a second distillation under reduced pressure was performed, and the residue was then filtered through a polypropylene mesh, yielding an aqueous solution of a compound (X-1) having phosphoric acid groups as the anionic functional group (yield: 1,030 g, non-volatile fraction: 58.8%, acid value: 488). The weight-average molecular weight of the resin (compound (X-1)) measured by gel permeation chromatography was about 5,000.

### [Synthesis of Aqueous Dispersion of Complex of Compound (X-1) and Silver Nanoparticles] (not part of the invention)

A reaction vessel was charged with a solution prepared by dissolving 14.6 g of the aqueous solution of the compound (X-1) having phosphoric acid groups as the anionic functional group obtained in the above synthesis in a mixture of 31 g (0.35 mol) of 2-dimethylaminoethanol, 34 g (0.35 mol) of 65% nitric acid and 39 g of distilled water, a solution prepared by dissolving 150 g of silver nitrate in 150 g of distilled water was then added, and finally, 34.5 g (0.39 mol) of 2-dimethylaminoethanol was added. The reaction vessel was immersed in an oil bath and heated to an internal temperature of 50°C for 4 hours, thus yielding a blackish brown dispersion.

The dispersion obtained following completion of the above reaction was subjected to purification by ultrafiltration using a hollow fiber UF membrane module (manufactured by Daicen Membrane Systems Ltd., membrane surface area: 0.13 m²). The electrical conductivity of the filtrate was initially greater than 20 mS/cm, and the ultrafiltration was continued until this value fell to 10 µS/cm or less. Subsequently, in order to remove coarse particles from the residual component, a suction filtration was performed using a membrane filter with a pore size of 0.45 µm, thus obtaining an aqueous dispersion of a complex with the silver nanoparticles as the filtrate (1,050 g, non-volatile fraction: 8.9%, yield: 89%). The filtered matter (coarse particles) was 9.0 g (equivalent to 8.5% of the raw material silver).

The thus obtained aqueous dispersion was sampled and diluted 10-fold to form a yellowish brown solution, and measurement of the visible absorption spectrum revealed a peak at 400 nm in the plasmon absorption spectrum, confirming the formation of silver nanoparticles.

### <Synthesis Example 2: Synthesis of Complex of Compound having Carboxyl Group and Silver Nanoparticles>

### [Synthesis of Compound (X-2) having Carboxyl Group]

70 parts of methyl ethyl ketone (hereafter abbreviated as MEK) were held at 80°C under a stream of nitrogen, and a mixture composed of 10 parts of methacrylic acid, 10 parts of benzyl methacrylate, 80 parts of Blemmer PME-1000 (manufactured by NOF Corporation), 2 parts of thioglycolic acid, 80 parts of MEK, and 4 parts of a polymerization initiator ("Perbutyl" (a registered trademark) O, manufactured by NOF Corporation) was added dropwise over a period of 2 hours with constant stirring. Following completion of the dropwise addition, an additional 2 parts of Perbutyl (a registered trademark) O were added, and stirring was continued at 80°C for a further 22 hours. Water was added to the thus obtained reaction mixture, and following removal of the solvents under reduced pressure, the non-volatile fraction was adjusted by adding water. In this manner, an aqueous solution of a compound (X-2) having carboxyl groups as the anionic functional group was obtained (non-volatile fraction: 33%). The weight-average molecular weight of the resin (compound (X-2)) measured by gel permeation chromatography was 10,000, and the acid value was 76.5 mgKOH/g.

### [Synthesis of Aqueous Dispersion of Complex of Compound (X-2) and Silver Nanoparticles]

The compound (X-2) obtained in the above synthesis (a solid fraction equivalent of 0.578 g) was dissolved in 12 mL of water, and 12 mL of 1 mol/L nitric acid was added to the solution. Subsequently, a solution prepared by dissolving 2.00 g (11.77 mmol) of silver nitrate in 35 mL of water was added, 8.78 g (58.85 mmol) of triethanolamine was then added, and the resulting mixture was stirred at 60°C for 2.5 hours. The thus obtained suspension was filtered using an ultrafiltration unit (Vivaspin 20, manufactured by Sartorius Stedim Biotech S.A., molecular weight cutoff: 100,000, 4 units). Purified water was added to the filtration residue, and centrifugal filtration was repeated a total of 4 times, and water was then added to the finally obtained residue, yielding 4.23 g of an aqueous dispersion of a complex of the compound (X-2) and silver nanoparticles (solid fraction: about 30 w/w%, silver content within solid fraction: 94.8% (TG-DTA), particle size: 5 to 40 nm (TEM)).

### <Synthesis Example 3: Synthesis of Complex of Compound having Carboxyl Group and Copper Nanoparticles>

### [Synthesis of Aqueous Dispersion of Complex of Compound (X-2) and Copper Nanoparticles]

The compound (X-2) obtained in Synthesis Example 2 (a solid fraction equivalent of 2.00 g) was dissolved in 40 mL of water, and a solution prepared by dissolving 10.0 g (50.09 mmol) of copper acetate hydrate in 500 mL of water was added. Subsequently, 10 g of an 80% aqueous solution of hydrazine (about 160 mmol) was added dropwise over a period of about 2 hours so that gentle foaming occurred, and the mixture was then stirred for an additional one hour at room temperature until the foaming stopped, thus obtaining a dark brown solution.

This solution was passed through an ultrafiltration unit (Vivaflow 50, manufactured by Sartorius Stedim Biotech S.A., molecular weight cutoff: 50,000, 1 unit), and purification was continued by passing additional deaerated water through the ultrafiltration unit until about 1 L of permeate had been obtained. The supply of deaerated water was then stopped, and subsequent concentration yielded 15 g of an aqueous dispersion of a complex of the compound (X-2) and copper nanoparticles (solid fraction: about 20 w/w%). When one drop of this aqueous dispersion was dissolved in ethanol (50 mL), a red solution was obtained, and when the UV-VIS absorption spectrum of this solution was measured, an absorption attributable to plasmon resonance of the copper nanoparticles was observed in the vicinity of 600 nm.

### <Synthesis Example 4: Synthesis of Complex of Compound having Phosphoric Acid Group and Silver Nanoparticles>

### [Synthesis of Compound (X-3) having Phosphoric Acid Group]

Under a nitrogen atmosphere, a reaction vessel was charged with 210 g of ethanol and 174 g of 2-butanone, and the mixture was heated to 75°C under stirring. A mixed solution prepared by dissolving 120 g of Light Ester P-1M (manufactured by Kyoeisha Chemical Co., Ltd.), 450 g of Blemmer PME-1000 (manufactured by NOF Corporation) and 30 g of Blemmer PME-100 (manufactured by NOF Corporation) in a mixed solvent of 90 g of ethanol and 90 g of 2-butanone was then added dropwise to the reaction vessel over a period of 3.5 hours, and a solution prepared by dissolving 3 g of a polymerization initiator V-59 and 18 g of a chain transfer agent (methyl 3-mercaptopropionate) in 30 g of 2-butanone was also added dropwise simultaneously over a period of 4.5 hours. Heating was halted 21 hours after the start of the reaction, and following cooling to room temperature, 300 g of distilled water was added. The solvents were removed by distillation under reduced pressure using a rotary evaporator, a further 100 g of distilled water was added, a second distillation under reduced pressure was performed, and the residue was then filtered through a polypropylene mesh, yielding an aqueous solution of a compound (X-3) having phosphoric acid groups as the anionic functional group (yield: 950 g, non-volatile fraction: 62.6%, acid value: 99). The weight-average molecular weight of the resin (compound (X-3)) measured by gel permeation chromatography was about 7,000.

The results of ¹H-NMR measurement of the thus obtained product are shown below.
1H-NMR (CD₃OD) measurement results:
δ (ppm): 3.85 to 4.45 (bs), 3.45 to 3.75 (bs), 3.20 to 3.40, 2.65 to 2.95 (bs), 2.40 to 2.65 (bs), 1.75 to 2.35 (bs), 0.75 to 1.50 (m).

### [Synthesis of Aqueous Dispersion of Complex of Compound (X-3) and Silver Nanoparticles]

A reaction vessel was charged with a solution prepared by dissolving 15.5 g of the aqueous solution of the compound (X-3) obtained above in a mixture of 155 g (1.75 mol) of 2-dimethylaminoethanol, 170 g (1.75 mol) of 65% nitric acid and 195 g of distilled water, a solution prepared by dissolving 150 g of silver nitrate in 150 g of distilled water was then added, and finally, 172.5 g (1.95 mol) of 2-dimethylaminoethanol was added. The reaction vessel was immersed in an oil bath and heated to an internal temperature of 50°C for 4 hours, thus yielding a blackish brown dispersion.

The dispersion obtained following completion of the above reaction was subject to purification by ultrafiltration using a hollow fiber UF membrane module (manufactured by Daicel Membrane Systems Ltd., membrane surface area: 0.13 m²). The electrical conductivity of the filtrate was initially greater than 20 mS/cm, and the ultrafiltration was continued until this value fell to 10 µS/cm or less. Subsequently, in order to remove coarse particles from the residual component, a suction filtration was performed using a membrane filter with a pore size of 0.45 µm, thus obtaining an aqueous dispersion of a complex with the silver nanoparticles as the filtrate (1,029 g, non-volatile fraction: 9.9%, yield: 97%). The filtered matter (coarse particles) was 135 mg (equivalent to 0.14% of the raw material silver).

The thus obtained dispersion was sampled and diluted 10-fold to form a yellowish brown liquid, and measurement of the visible absorption spectrum revealed a peak at 400 nm in the plasmon absorption spectrum, confirming the formation of silver nanoparticles. Further, TEM observation confirmed the existence of spherical silver particles (average particle size: 6.8 nm). Measurement of the silver content within the solid fraction using TG-DTA revealed a result of 93.5%, enabling the amount of the compound (X-3) within the complex to be estimated as 6.5%.

### <Synthesis Example 5: Synthesis of Complex of Compound having Phosphoric Acid Group and Copper Nanoparticles>

### [Synthesis of Aqueous Dispersion of Complex of Compound (X-3) and Copper Nanoparticles]

First, 3.19 g (a solid fraction equivalent of 2.00 g) of the aqueous dispersion of the compound (X-3) obtained in the above Synthesis Example 4 was weighed into a reaction vessel and diluted with 40 mL of water. A solution prepared by dissolving 10.0 g (50.09 mmol) of copper acetate hydrate in 500 mL of water was then added. Subsequently, 10 g of an 80% aqueous solution of hydrazine (about 160 mmol) was added dropwise to the solution over a period of about 2 hours so that gentle foaming occurred, and the mixture was then stirred for an additional one hour at room temperature until the foaming stopped, thus obtaining a reddish brown solution.

This solution was passed through an ultrafiltration module (manufactured by Daicen Membrane Systems Ltd., molecular weight cutoff: 150,000), and purification was continued by passing additional purified water that had been deaerated by nitrogen bubbling through the ultrafiltration module until about 1 L of permeate had been obtained. The supply of deaerated water was then stopped, and subsequent concentration yielded 15 g of an aqueous dispersion of a complex of the compound (X-3) and copper nanoparticles (solid fraction: about 20 w/w%). When one drop of this aqueous dispersion was dissolved in ethanol (50 mL), a red solution was obtained, and when the UV-VIS absorption spectrum of this solution was measured, an absorption attributable to plasmon resonance of the copper nanoparticles was observed in the vicinity of 600 nm.

### <Synthesis Example 6: Synthesis of Complex of Compound having Phosphoric Acid Group and Palladium Nanoparticles>

### [Synthesis of Aqueous Dispersion of Complex of Compound (X-3) and Palladium Nanoparticles]

The compound (X-3) obtained above in Synthesis Example 4 (a solid fraction equivalent of 0.102 g) was dissolved in 5 mL of water, and a solution prepared by dissolving palladium(II) nitrate (585 mg. 2.54 mmol) in 5 mL of water was added. A mixture of 1.81 g (20.31 mmol) of dimethylaminoethanol and 5 mL of water was then added, and the resulting mixture was stirred at room temperature for 2 hours. The thus obtained mixture was divided, fed into an ultrafiltration unit (Vivaspin 20, manufactured by Sartorius Stedim Biotech S.A., molecular weight cutoff: 50,000, 2 units), and filtered by centrifugal force (5,800 G). Purified water was added to the filtration residue, and centrifugal filtration was repeated a total of 4 times, and water was then added to the finally obtained residue to make the total mass up to 2.5 g, thus yielding an aqueous dispersion of a complex of the compound (X-3) and palladium nanoparticles (solid fraction: about 10 w/w%). This aqueous dispersion was brown in color, and when one drop of the dispersion was dissolved in ethanol (50 mL) and the UV-VIS spectrum was measured, a weak absorption was confirmed in the vicinity of about 520 nm.

### <Synthesis Example 7: Synthesis of Complex of Compound having Sulfonic Acid Group and Silver Nanoparticles>

### [Synthesis of Compound (X-4) having Sulfonic Acid Group]

40 parts of 70 w/w% ethanol was held at 80°C under a stream of nitrogen, and a mixture composed of 10 parts of 2-acrylamido-2-methylpropanesulfonic acid, 5 parts of methoxy polyethylene glycol methacrylate (molecular weight: 100), 85 parts of methoxy polyethylene glycol methacrylate (molecular weight: 1,000), 5 parts of methyl β-mercaptopropionate and 80 parts of 70 w/w% ethanol, and a mixture composed of 0.5 parts of a polymerization initiator ("Perbutyl" (a registered trademark) O, manufactured by NOF Corporation) and 5 parts of ethanol were added dropwise over a period of 2 hours with constant stirring. Following completion of the dropwise addition, an additional 1 part of Perbutyl (a registered trademark) O was added, and stirring was continued at 80°C for a further 12 hours.

Ion-exchanged water was added to the thus obtained reaction solution, and following removal of the solvents under reduced pressure, the non-volatile fraction was adjusted by adding water. In this manner, an aqueous solution of a compound (X-4) having sulfonic acid groups as the anionic functional group was obtained (non-volatile fraction: 40%). The weight-average molecular weight measured by gel permeation chromatography was 5,800, and the acid value was 54.1 mgKOH/g.

### [Synthesis of Aqueous Dispersion of Complex of Compound (X-4) and Silver Nanoparticles]

First, 0.245 g (a solid fraction equivalent of 0.098g) of the compound (X-4) obtained in the above synthesis was dissolved in 6 mL of water, and 6 mL of 1 mol/L nitric acid was added to the solution. Subsequently, a solution prepared by dissolving 1.00 g (5.89 mmol) of silver nitrate in 17.5 mL of water was added, 4.39 g (29.43 mmol) of triethanolamine was then added, and the resulting mixture was stirred at 60°C for 2.5 hours. The thus obtained suspension was filtered using an ultrafiltration unit (Vivaspin 20, manufactured by Sartorius Stedim Biotech S.A., molecular weight cutoff: 100,000, 2 units). Purified water was added to the filtration residue, and centrifugal filtration was repeated a total of 4 times, and water was then added to the obtained residue to make the total mass of the resulting dispersion up to 2.1 g, thus yielding an aqueous dispersion of a complex of the compound (X-4) and silver nanoparticles (solid fraction: about 30 w/w%, silver content within the solid fraction: 96.2% (TG-DTA), particle size: 40 to 50 nm (TEM)).

### <Comparative Synthesis Example 1: Synthesis of Silver Hydrosol using Non-Polymerizable Compound having Cationic Functional Group>

Based on Example 1 of Patent Document 3, a solution prepared by dissolving 50 µmol of silver nitrate in 94 mL of pure water was stirred vigorously while 1 mL of an aqueous solution containing 10 mg of stearyltrimethylammonium chloride and then 5 mL of an aqueous solution containing 200 µmol of sodium borohydride were added sequentially, and this caused the color of the solution to change to a yellowish brown color, yielding 100 mL of a uniform transparent silver hydrosol containing 0.5 mg of silver particles.

### <Comparative Synthesis Example 2: Synthesis of Silver Hydrosol using Non-Polymerizable Compound having Sulfonic Acid Group>

Based on Patent Document 3, but with the exception of using sodium dodecylbenzenesulfonate instead of the surfactant stearyltrimethylammonium chloride, a uniform transparent hydrosol was prepared in the same manner as Comparative Synthesis Example 1.

### <Comparative Synthesis Example 3: Synthesis of Silver Hydrosol using Compound having Polyethylene Glycol Chain but not having Anionic Functional Group>

Based on Patent Document 3, but with the exception of using polyethylene glycol p-nonylphenyl ether instead of the surfactant stearyltrimethylammonium chloride, a uniform transparent hydrosol was prepared in the same manner as Comparative Synthesis Example 1.

### <Comparative Synthesis Example 4: Synthesis of Silver Hydrosol Simultaneously Containing Non-Polymerizable Compound having Sulfonic Acid Group and Compound having Polyethylene Glycol Chain>

Based on Patent Document 3, but with the exception of using 1 mL of an aqueous solution containing 5 mg of sodium dodecylbenzenesulfonate and 5 mg of polyethylene glycol p-nonylphenyl ether instead of the surfactant stearyltrimethylammonium chloride, a uniform transparent hydrosol was prepared in the same manner as Comparative Synthesis Example 1.

### <Comparative Synthesis Example 5: Synthesis of Silver Hydrosol using Water-Soluble Polymer not having Anionic Functional Group>

Based on Patent Document 3, but with the exception of using a water-soluble polyvinylpyrrolidone polymer instead of the surfactant stearyltrimethylammonium chloride, a uniform transparent hydrosol was prepared in the same manner as Comparative Synthesis Example 1.

### <Dispersibility of Hydrosols Obtained in Comparative Synthesis Examples 1 to 5>

When the silver hydrosols obtained in Comparative Synthesis Examples 1 to 5 were concentrated down to 0.5 g/L using an evaporator, each of the hydrosols exhibited aggregation of the silver colloid, and a stable dispersion could not be maintained.

The aqueous dispersions of the complexes of a compound and metal nanoparticles obtained in Synthesis Examples 1 to 7 were each diluted with purified water to a prescribed concentration and used as catalyst solutions 1 to 8. Similarly, the hydrosols obtained in Comparative Synthesis Examples 1 to 5 were each diluted with purified water to a concentration of 0.05 g/L and used as comparative catalyst solutions 1 to 5. The catalyst solutions prepared from the dispersions of Synthesis Examples 1 to 7 and Comparative Synthesis Examples 1 to 5 are shown in Table 1.

**[Table 1]**

| | Compound | Anionic functional group | Existence of PEG chain | Metal type | Catalyst solution (Concentration of the complex) | |
|---|---|---|---|---|---|---|
| Synthesis Example 1 (*) | X-1 | phosphoric acid group | no | Ag | catalyst solution 1 | 0.5 g/L |
| Synthesis Example 2 | X-2 | carboxyl group | yes | Ag | catalyst solution 2 | 0.5 g/L |
| Synthesis Example 3 | X-2 | carboxyl group | yes | Cu | catalyst solution 3 | 0.5 g/L |
| Synthesis Example 4 | X-3 | phosphoric acid group | yes | Ag | catalyst solution 4 | 0.5 g/L |
| Synthesis Example 5 | X-3 | phosphoric acid group | yes | Cu | catalyst solution 5 | 0.5 g/L |
| Synthesis Example 6 | X-3 | phosphoric acid group | yes | Pd | catalyst solution 6 | 0.5 g/L |
| Synthesis Example 7 | X-4 | sulfonic acid group | yes | Ag | catalyst solution 7 | 0.5 g/L |
| Synthesis Example 4 | X-3 | phosphoric acid group | yes | Ag | catalyst solution 8 | 0.2 g/L |
| Comparative Synthesis Example 1 | cationic | none | no | Ag | comparative catalyst solution 1 | 0.05 g/L |
| Comparative Synthesis Example 2 | sodium dodecylbenzene sulfonate | sulfonic acid group | no | Ag | comparative catalyst solution 2 | 0.05 g/L |
| Comparative Synthesis Example 3 | neutral | none | yes | Ag | comparative catalyst solution 3 | 0.05 g/L |
| Comparative Synthesis Example 4 | sodium dodecylbenzene sulfonate | sulfonic acid group | yes (coexistence) | Ag | comparative catalyst solution 4 | 0.05 g/L |
| Comparative Synthesis Example 5 | neutral | none | no | Ag | comparative catalyst solution 5 | 0.05 g/L |

| | | | | | | |
|---|---|---|---|---|---|---|
| (*) not part of the invention | | | | | | |

### <Example 1: Preparation of Electroless Plating Copper Films using Catalyst Solutions 1 to 7>

Using the catalyst solutions 1 to 7, electroless plating was performed onto the objects to be plated described below, using the steps described below.

### [Objects to be Plated]

1. Glass fiber-reinforced epoxy resin substrate: FR-4 standard copper-clad substrate (substrate thickness: 1.6 mm, copper foil thickness: 18 µm)
2. A resin substrate prepared by drilling portions of the FR-4 standard copper-clad substrate of 1 to form through-holes of hole length 1.6 mm × hole diameter 0.8 mm, dipping the substrate in an aqueous solution of sodium persulfate, and then removing the copper foil by etching.
3. Interlayer insulating material for built-up substrate:
   A material prepared by dipping the copper foil surface of an FR-4 substrate (substrate thickness: 0.8 mm, copper foil thickness: 18 µm) in "CZ8100" and "CZ8300" (manufactured by MEC Co., Ltd.) to perform a surface roughening treatment, subsequently vacuum laminating an epoxy resin-based insulating material "ABF-GX13" (thickness: 40 µm) or "ABF-GX92" (thickness: 40 µm) to the substrate, and then performing a desmear treatment.

The substrate desmear treatment was performed using the operations described below.
1) Swelling step: the substrate was dipped for 10 minutes in 1 L of water at 60°C containing 500 mL/L of OPC-1080 Conditioner (manufactured by Okuno Chemical Industries Co., Ltd.) and 15 g/L of sodium hydroxide, and was then washed with water.
2) Microetching step: the substrate that had been treated in 1) was dipped for 20 minutes in 1 L of water at 85°C containing 30 g/L of KMnO₄ and 200 mL/L of "OPC1200 Epoetch" (manufactured by Okuno Chemical Industries Co., Ltd.), and was then washed with water.
3) Neutralization step: the substrate that had been treated in 2) was dipped for 5 minutes in 1 L of water at 45°C containing 200 mL/L of OPC-1300 Neutralizer (manufactured by Okuno Chemical Industries Co., Ltd.), and was then washed with water to complete the desmear treatment.

### [Electroless Plating Process]

### 1. Cleaning and conditioning step:

25 mL of a cleaning and conditioning agent (OPC Condiclean FCR, manufactured by Okuno Chemical Industries Co., Ltd.) was dissolved in water, and the resulting solution was made up to 500 mL and held at 65°C. The object to be plated was dipped in this solution for 5 minutes. This step cleaned and cationized the surface of the object to be plated, and the object was subsequently washed for 2 minutes in hot water, and then washed for 2 minutes under running water.

### 2. Soft etching step:

First, 50 g of sodium persulfate and 2.5 mL of 98% pure sulfuric acid were dissolved in water, and the resulting solution was made up to 500 mL and held at 25°C. The object to be plated that had been subjected to the cleaning and conditioning step was dipped in the solution for 2 minutes, and was then washed under running water for 2 minutes.

### 3. Desmutting step:

50 mL of 98% pure sulfuric acid was dissolved in water, and the resulting solution was made up to 500 mL and held at 25°C. The object to be plated that had been subjected to the soft etching step was dipped in the solution for 2 minutes, and was then washed under running water for 2 minutes. The object was then further washed for one minute in pure water.

### 4. Catalyst deposition step:

Each of the catalyst solutions 1 to 7 was held at 25°C, and an object to be plated that had been subjected to the desmutting step was dipped in the catalyst solution for 5 minutes to adsorb the complex to the surface of the object to be plated.

### 5. Electroless plating step:

Electroless copper plating reagents ("MOON-700 Copper-1" (15 mL), "MOON-700 Copper-2" (15 mL), and "MOON-700 Copper-3" (100 mL), all manufactured by Okuno Chemical Industries Co., Ltd.) were mixed with water, and the resulting solution was made up to 500 mL and held at 45°C. The object to be plated that had been subjected to the catalyst deposition step was dipped in the solution for 15 minutes to deposit a copper plated coating film.

Evaluations of the obtained plated coating films were performed using the methods described below.

### [Evaluation of Copper Plated Coating Film]

### 1. Coating film coverage (%):

The surface area of the object being plated and the surface area of the formed copper plated coating film were measured, and the coverage was calculated from the ratio between the two areas.

### 2. Through-hole plating property:

Under a 100× optical microscope, light was irradiated onto the underside of a through-hole portion, and the degree of through-hole filling by the plating was evaluated by observing the level of light transmittance.

### 3. Inspection of plated coating film cross-section:

The copper plated coating film was cut using a Ga-focused ion beam method (FIB method), and the cross-section was inspected using an SEM. This inspection enabled evaluation of the throwing power in the via hole portions.

### <Comparative Example 1: Electroless Copper Plated Films using Sn-Pd Colloidal Catalyst>

Using a commercially available palladium-tin colloid instead of the catalyst solutions used in Example 1, the same objects to be plated as those described in Example 1 were subjected to electroless plating. Steps 1 to 3 were the same as described in Example 1, but as described below, the subsequent steps were more complex and required an extra two steps, namely a predipping step and an activation step.

### 4. Predipping step:

First, 130 g of a predipping reagent ("OPC-SAL-M", manufactured by Okuno Chemical Industries Co., Ltd.) was diluted with water, made up to 500 mL, and held at 25°C. The object to be plated that had been subjected to the desmutting step was then dipped in the solution for one minute.

### 5. Catalyst compound deposition step:

First, 130 g of a predipping reagent (OPC-SAL-M, manufactured by Okuno Chemical Industries Co., Ltd.) and 15 mL of an Sn-Pd colloidal catalyst reagent (OPC-90 Catalyst, manufactured by Okuno Chemical Industries Co., Ltd.) were diluted with water, made up to 500 mL, and held at 25°C. The object to be plated that had been subjected to the above predipping step was then immersed in the solution for 5 minutes, and was then washed under running water for 2 minutes.

### 6. Activation step:

First, 50 mL of an activation reagent ("OPC-505 Accelerator A", manufactured by Okuno Chemical Industries Co., Ltd.) and 4 mL of another activation reagent ("OPC-505 Accelerator B", manufactured by Okuno Chemical Industries Co., Ltd.) were diluted with water, made up to 500 mL, and held at 30°C. The object to be plated that had been subjected to the above catalyst compound deposition step was then immersed in the solution for 5 minutes, and was then washed under running water for 2 minutes.

### 7. Electroless plating step:

Electroless copper plating was performed using the aforementioned MOON-700 Copper series (manufactured by Okuno Chemical Industries Co., Ltd., electroless copper plating reagents), thereby forming a copper plated film on the object to be plated that had been subjected to the above activation step.

### <Comparative Example 2: Electroless Copper Plated Films using Pd Colloidal Catalyst>

Using a commercially available palladium colloid instead of the catalyst solutions used in Example 1, the same objects to be plated as those described in Example 1 were subjected to electroless plating using the steps described below. Because of the requirement for a predipping step and an activation step, the process was more complex than that described in Example 1, and required an extra two steps.

### 1. Cleaning and conditioning step:

50 mL of a cleaning and conditioning reagent (OPC-370 Condiclean MA, manufactured by Okuno Chemical Industries Co., Ltd.) was dissolved in water, and the resulting solution was made up to 500 mL and held at 65°C. The object to be plated was dipped in this solution for 5 minutes. This step cleaned and cationized the surface of the object to be plated, and the object was subsequently washed for 2 minutes in hot water, and then washed for 2 minutes under running water.

### 2. Soft etching step:

A soft etching step using sodium persulfate was performed in the same manner as Example 1.

### 3. Desmutting step:

A desmutting step using sulfuric acid was performed in the same manner as Example 1.

### 4. Predipping step:

First, 5 mL of a predipping reagent ("OPC Predip 49L", manufactured by Okuno Chemical Industries Co., Ltd.) and 0.75 ml of 98% pure sulfuric acid were dissolved in water, and the resulting solution was made up to 500 mL and held at 25°C. The object to be plated that had been subjected to the desmutting step was then dipped in the solution for one minute.

### 5. Catalyst compound deposition step:

First, 25 mL of each of two Pd colloidal catalyst precursor reagents (OPC-50 Inducer A and OPC-50 Inducer C, both manufactured by Okuno Chemical Industries Co., Ltd.) were dissolved in water, and the resulting solution was made up to 500 mL and held at 40°C. The object to be plated that had been subjected to the above predipping step was then immersed in the solution for 5 minutes, and was then washed under running water for 2 minutes.

### 6. Activation step:

First, 75 mL of an activation reagent ("OPC-150 Cryster MU", manufactured by Okuno Chemical Industries Co., Ltd.) was dissolved in water, and the resulting solution was made up to 500 mL, and held at 25°C. The object to be plated that had been subjected to the above catalyst compound deposition step was then immersed in the solution for 5 minutes, and was then washed under running water for 2 minutes.

### 7. Electroless plating step:

Electroless copper plating was performed using the aforementioned MOON-700 Copper series (manufactured by Okuno Chemical Industries Co., Ltd., electroless copper plating reagents), thereby forming a copper plated film on the object to be plated that had been subjected to the above activation step.

### <Comparative Example 3: Electroless Copper Plated Coating Films using Sn-Ag Colloidal Catalyst>

Using a commercially available tin-silver colloidal catalyst instead of the catalyst solutions used in Example 1, the same objects to be plated as those described in Example 1 were subjected to electroless plating using the steps described below. Because of the requirement for an activation step to remove Sn, the process was more complex than that described in Example 1, and required an extra step.

### 1. Cleaning and conditioning step:

50 mL of a cleaning and conditioning reagent (MOON-300 Condiclean, manufactured by Okuno Chemical Industries Co., Ltd.) was dissolved in water, and the resulting solution was made up to 500 mL and held at 60°C. The object to be plated was dipped in this solution for 5 minutes. This step degreased and cationized the surface of the object to be plated, and the object was subsequently washed for 2 minutes in hot water, and then washed for 2 minutes under running water.

### 2. Soft etching step:

A soft etching step using sodium persulfate was performed in the same manner as Example 1.

### 3. Desmutting step:

A desmutting step using sulfuric acid was performed in the same manner as Example 1.

### 4. Catalyst compound deposition step:

An Sn-Ag catalyst solution ("MOON-500 Catalyst", manufactured by Okuno Chemical Industries Co., Ltd.) was held at 25°C. The object to be plated that had been subjected to the above desmutting step was then immersed in the solution for 5 minutes, and was then washed under running water for 2 minutes.

### 5. Activation step:

First, 50 mL of an activation reagent ("MOON-600 Accelerator", manufactured by Okuno Chemical Industries Co., Ltd.) was dissolved in water, and the resulting solution was made up to 500 mL, and held at 45°C. The object to be plated that had been subjected to the above catalyst compound deposition step was then immersed in the solution for 5 minutes, and was then washed under running water for 2 minutes.

### 6. Electroless plating step:

Electroless copper plating was performed using the aforementioned MOON-700 Copper series (manufactured by Okuno Chemical Industries Co., Ltd., electroless copper plating reagents), thereby forming a copper plated film on the object to be plated that had been subjected to the above activation step.

### <Comparative Example 4: Preparation of Electroless Plating Films using Comparative Catalyst Solutions 1 to 5>

With the exception of replacing the catalyst solution in Example 1 with the comparative catalyst solutions 1 to 5, the objects to be plated were subjected to electroless plating in the same manner as that described in Example 1.

The physical properties of the plated coating films obtained in Example 1 and Comparative Examples 1 to 4 are shown below.

**[Table 2]**

| | Complex catalyst solution | Concentration (g/L) | Plating coverage (%) | | | Through-hole plating property |
|---|---|---|---|---|---|---|
| | Name | | FR-4 | ABF-GX13 | ABF-GX92 | |
| Example 1 | Catalyst solution 1 (*) | 0.5 | 100 | 100 | 100 | good |
| | Catalyst solution 2 | | 100 | 100 | 100 | good |
| | Catalyst solution 3 | | 100 | 100 | 100 | good |
| | Catalyst solution 4 | | 100 | 100 | 100 | good |
| | Catalyst solution 5 | | 100 | 100 | 100 | good |
| | Catalyst solution 6 | | 100 | 100 | 100 | good |
| | Catalyst solution 7 | | 100 | 100 | 100 | good |
| Comparative Example 1 | Sn-Pd colloid | - | 100 | 100 | 100 | good |
| Comparative Example 2 | Pd colloid | - | 100 | 100 | 100 | good |
| Comparative Example 3 | Sn-Ag colloid | - | 100 | 100 | 100 | good |
| Comparative Example 4 | Comparative catalyst solution 1 | 0.05 | 0 | 0 | 0 | × |
| | Comparative catalyst solution 2 | | 15 | 10 | 5 | × |
| | Comparative catalyst solution 3 | | 5-10 | 5 | 1-5 | × |
| | Comparative catalyst solution 4 | | 10-15 | 10 | 5 | × |
| | Comparative catalyst solution 5 | | 5-10 | 5 | 1-5 | × |

| | | | | | | |
|---|---|---|---|---|---|---|
| (*) not part of the invention | | | | | | |

### <Example 2>

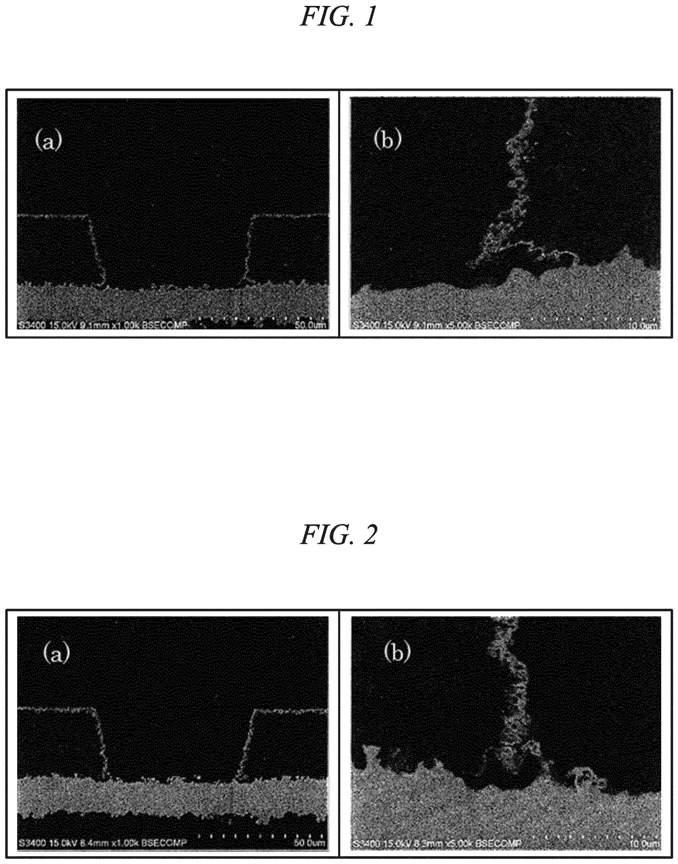

Using substrates prepared by forming via holes with a hole diameter of 70 µm in the interlayer insulating material for a built-up substrate having ABF-GX92 laminated thereto that was prepared in Example 1, the catalyst solution 4 and the Sn-Pd colloidal catalyst used in Comparative Example 1 were each used to perform electroless plating to the surface of an object to be plated in the same manner as that described in Example 1. In order to confirm the throwing power of the plating into the via holes, the via hole portions were cut using an FIB method, and when the resulting cross-sections were inspected by SEM, it was confirmed that the simple method of the present invention having two fewer steps than that required for the Sn-Pd colloidal catalyst exhibited a similar level of throwing power. FIG. 1 illustrates cross-sectional SEM photographs of the substrate that was subjected to the plating treatment using the catalyst solution 4, and FIG. 2 illustrates cross-sectional SEM photographs of the substrate that was subjected to the plating treatment using the Sn-Pd catalyst solution used in Comparative Example 1.

### <Example 3: Preparation of Electroless Plating Coating Films of Copper using Catalyst Solutions 1 to 8>

Using a different cleaning and conditioning agent and different electroless copper plating reagents from those described above, the catalyst solutions 1 to 8 were used to perform electroless plating to the objects to be plated described below in accordance with the process described below.

Using the electroless plating process described above, but with the exceptions of using a NACE Conditioner (manufactured by Okuno Chemical Industries Co., Ltd.) (amount used: 50 mL) as the cleaning and conditioning agent of step 1, using NACE Copper-1 (15 mL), NACE Copper-2 (15 mL) and NACE Copper-3 (100 mL) (all manufactured by Okuno Chemical Industries Co., Ltd.) as the electroless copper plating reagents of step 5, and altering the holding temperature in step 5 to 40°C, copper plated coating films were deposited in the same manner as the electroless plating process described above.

Evaluations of the obtained plated coating films were performed in the same manner as Example 1, and the results are shown in Table 3.

**[Table 3]**

| | Complex catalyst solution | Concentration (g/L) | Plating coverage (%) | | Through-hole plating property |
|---|---|---|---|---|---|
| | Name | | FR-4 | ABF-GX92 | |
| Example 3 | Catalyst solution 1 (*) | 0.5 | 100 | 100 | good |
| | Catalyst solution 2 | | 100 | 100 | good |
| | Catalyst solution 3 | | 100 | 100 | good |
| | Catalyst solution 4 | | 100 | 100 | good |
| | Catalyst solution 5 | | 100 | 100 | good |
| | Catalyst solution 6 | | 100 | 100 | good |
| | Catalyst solution 7 | | 100 | 100 | good |
| | Catalyst solution 8 | 0.2 | 100 | 100 | good |

| | | | | | |
|---|---|---|---|---|---|
| (*) not part of the invention | | | | | |

### INDUSTRIAL APPLICABILITY

The catalyst for electroless plating according to the present invention exhibits extremely good retention of the catalytic activity after initial make-up of electrolytic bath, enables simple process management, and exhibits satisfactory adsorption (catalyst deposition) to the surfaces of objects to be plated that have been pretreated with a typical cationic treatment agent.

Further, the complex of the catalyst for electroless plating used according to the present invention can also be used favorably for plating catalyst applications which require superior reliability, such as the production of electronic circuit boards.

Furthermore, the metal film obtained using the catalyst for electroless plating according to the present invention compares favorably with plated metal films obtained using conventional palladium-based catalysts, and because the associated costs are extremely cheap compared with palladium, and the risk of price fluctuations is also minimal, significant economic benefits can be expected.

Moreover, by using the catalyst for electroless plating and the method for producing a metal film according to the present invention, the number of steps can be reduced compared with conventionally used electroless plating processes, thus enabling a significant reduction in the process costs, and therefore the invention is very useful industrially.

## Claims

1. A method for producing an electroless plating metal film, using, as a catalyst, a complex of a compound (X) and metal nanoparticles (Y), in which the compound (X) is produced by polymerizing a monomer mixture (I) comprising a (meth)acrylic acid-based monomer having at least one anionic functional group selected from the group consisting of a carboxyl group, a phosphoric acid group, a phosphorous acid group, a sulfonic acid group, a sulfinic acid group and a sulfenic acid group, the method comprising:
(1) a step of treating a surface of an object to be plated with a cationic treatment agent (a),
(2) a step of dipping the object to be plated that has been subjected to step (1) in a catalyst for electroless plating comprising said catalyst dispersed in an aqueous solvent, thereby adsorbing the complex of the compound (X) and the metal nanoparticles (Y) to a surface of the object to be plated, and
(3) a step of dipping the complex-adsorbed object to be plated obtained in step (2) in a solution of metal ions (b) for performing electroless plating, wherein
the monomer mixture (I) further comprises a (meth)acrylic acid-based monomer having a polyethylene glycol chain in which an average number of ethylene glycol units is 20 or greater, and
an average particle size of the metal nanoparticles (Y) determined from a transmission electron microscope photograph is within a range from 0.5 to 100 nm.

2. The method for producing an electroless plating metal film according to claim 1, wherein a weight-average molecular weight of the compound (X) is within a range from 3,000 to 20,000.

3. The method for producing an electroless plating metal film according to claim 1 or 2, wherein the metal of the metal nanoparticles (Y) is silver, copper or palladium.

## Patentansprüche

1. Verfahren zur Herstellung eines Metallfilms durch stromlose Galvanisierung, das als Katalysator einen Komplex aus einer Verbindung (X) und Metallnanopartikeln (Y) verwendet, wobei die Verbindung (X) durch Polymerisieren eines Monomerengemisches (I), das ein (Meth)acrylsäure-basiertes Monomer, das wenigstens eine anionische funktionelle Gruppe hat, die aus der Gruppe, bestehend aus einer Carboxylgruppe, einer Phosphorsäuregruppe, einer phosphorigen Säure-Gruppe, einer Sulfonsäuregruppe, einer Sulfinsäuregruppe und einer Sulfensäuregruppe, ausgewählt ist, umfasst, hergestellt wird, wobei das Verfahren umfasst:
(1) einen Schritt einer Behandlung einer Oberfläche eines Gegenstandes, der beschichtet werden soll, mit einem kationischen Behandlungsmittel (a),
(2) einen Schritt des Eintauchens des zu beschichtenden Gegenstandes, der Schritt (1) unterzogen worden war, in einen Katalysator zur stromlosen Galvanisierung, der den Katalysator in einem wässrigen Lösungsmittel dispergiert, umfasst, wodurch der Komplex aus der Verbindung (X) und den Metallnanopartikeln (Y) an einer Oberfläche des zu beschichtenden Gegenstandes adsorbiert wird, und
(3) einen Schritt des Eintauchens des zu beschichtenden Gegenstandes mit adsorbierten Komplex, der in Schritt (2) erhalten wurde, in eine Lösung von Metallionen (b) zur Durchführung einer stromlosen Galvanisierung, wobei
das Monomerengemisch (I) außerdem ein (Meth)acrylsäurebasiertes Monomer umfasst, das eine Polyethylenglycolkette hat, in welcher die durchschnittliche Anzahl an Ethylenglycoleinheiten 20 oder mehr ist, und
die durchschnittliche Partikelgröße der Metallnanopartikel (Y), bestimmt aus einer Transmissionselektronenmikroskopaufnahme, in einem Bereich von 0,5 bis 100 nm liegt.

2. Verfahren zur Herstellung eines Metallfilms durch stromlose Galvanisierung gemäß Anspruch 1, wobei das gewichtsmittlere Molekulargewicht der Verbindung (X) in einem Bereich von 3.000 bis 20.000 liegt.

3. Verfahren zur Herstellung eines Metallfilms durch stromlose Galvanisierung gemäß Anspruch 1 oder 2, wobei das Metall der Metallnanopartikel (Y) Silber, Kupfer oder Palladium ist.

## Revendications

1. Procédé de production d'un film métallique par dépôt autocatalytique, utilisant comme catalyseur, un complexe d'un composé (X) et de nanoparticules (Y), dans lequel le composé (X) est produit en polymérisant un mélange de monomères (I), comprenant un monomère à base d'acide (méth)acrylique, comportant au moins un groupe fonctionnel anionique choisi dans le groupe constitué par un groupe carboxyle, un groupe acide phosphorique, un groupe acide phosphoreux, un groupe acide sulfonique, un groupe acide sulfinique et un groupe acide sulfenique, ledit procédé comprenant :
(1) une étape de traitement d'une surface d'un objet à revêtir avec un agent de traitement cationique (a) ;
(2) une étape d'immersion de l'objet à revêtir qui a été soumis à l'étape (1) dans un catalyseur pour le dépôt autocatalytique comprenant ledit catalyseur dispersé dans un solvant aqueux, dans laquelle le complexe du composé (X) et de nanoparticules (Y) est adsorbé à une surface de l'objet à revêtir, et
(3) une étape d'immersion de l'objet à revêtir qui a adsorbé ledit complexe et qui a obtenu dans l'étape (2), dans une solution d'ions métalliques (b) pour effectuer un dépôt autocatalytique, dans lequel le mélange de monomères (I) comprend en outre un monomère à base d'acide (méth)acrylique ayant une chaîne de polyéthylène glycol, dans laquelle un nombre moyen d'unités d'éthylène glycol est de 20 ou plus,
la taille moyenne des nanoparticules métalliques (Y), déterminée à partir d'une photographie d'un microscope électronique de transmission, est comprise dans la plage de 0,5 à 100 nm.

2. Procédé de production d'un film métallique par dépôt autocatalytique selon la revendication 1, dans lequel la masse moléculaire moyenne en poids du composé (X) est comprise dans une plage allant de 3000 à 20 000.

3. Procédé de production d'un film métallique par dépôt autocatalytique selon la revendication 1 ou 2, dans lequel le métal des nanoparticules métalliques (Y) est l'argent, le cuivre ou le palladium.
